# EUROPÄISCHE PATENTANMELDUNG

(11) **EP 2 711 666 A1**
(43) Veröffentlichungstag der Anmeldung: **26.03.2014**
(21) Anmeldenummer: 12185236.2
(22) Anmeldetag: 20.09.2012
(51) Int. Cl.: G01B 21/32, B31F 1/07, B21D 13/04, B21D 17/04

(54) **Verfahren zur Herstellung eines Satzes von miteinander kooperierenden Prägewalzen und Modellvorrichtung zur Durchführung des Verfahrens**

(71) Anmelder: Boegli-Gravures S.A., 2074 Marin-Epagnier (CH)
(72) Erfinder: Boegli, Charles, 2074 Marin (CH); Steffen, Werner, 6371 Stans (CH)
(74) Vertreter: Grosfillier, Philippe

(57) **Zusammenfassung**

Beim Verfahren zur Herstellung eines Satzes von miteinander kooperierenden Prägewalzen wird für die Parametrisierung der Prägewalzen eine Modellvorrichtung verwendet, die ein Paar Walzen aufweist, die unter mess- und einstellbaren Druck gesetzt werden, um aus den Messdaten die Parameter zur Herstellung der Prägewalzen zu bestimmen. Durch die Verwendung einer Modellvorrichtung zum Gewinnen der Parameter zur Herstellung eines Satzes von Prägewalzen, ist es möglich, rationell von einer sehr grossen Vielfalt von Prägemustern und Folien mit diversen Eigenschaften auszugehen.

## Beschreibung

Die vorliegende Erfindung bezieht sich auf ein Verfahren zur Herstellung eines Satzes von miteinander kooperierenden Prägewalzen für eine Vorrichtung zum Prägen von Verpackungsmaterialien. Verpackungsfolien für die Tabakindustrie oder für die Lebensmittelindustrie werden schon seit geraumer Zeit mit Prägewalzen-Vorrichtungen geprägt, wobei es sich z. B. um sogenannte Innerliner, die um eine Anzahl Zigaretten gehüllt werden oder um Verpackungsmaterial für Schokolade, Butter oder ähnliche Lebensmittel, Elektronikbauteile, Schmuck oder Uhren handeln kann.

Seit etwa 1980, nach dem Anmelden der US-5 007 271 des gleichen Anmelders, wurden vor allem in der Tabakindustrie zunehmend Stahlwalzen verwendet, die mit einer sehr grossen Anzahl von kleinen Zähnen ausgestattet sind, wodurch einerseits ein mattes Aussehen der im Normalzustand glänzenden Metallfolien erzielt wurde und andererseits eine Konditionierung der Folie um die Weiterverarbeitung zu vereinfachen. Durch gänzliches oder partielles Entfernen von Zähnen werden die sogenannten Logos erzeugt, die auch verschiedene optische Effekte zeigen können. Im Zuge der Verbesserung der Verfahren zur Herstellung von Walzen wurden die Zähne, bzw. deren Abstände voreinander immer kleiner und die Oberfläche der Zähne wird ebenfalls bearbeitet, um beispielsweise Authentifizierungsmerkmale oder auch Farbmuster durch Interferenz zu erzeugen.

Durch noch weiter verbesserte Herstellungsverfahren, beispielsweise mittels Laser, können auch Prägewalzen hergestellt werden, die keine Zähne aufweisen sondern nur noch Erhebungen und Vertiefungen, um die gewünschten Logos zu erzeugen. Gleichzeitig wurde dazu übergegangen, ausgehend von reinen Metallfolien metallisierte und beschichtete Folien zu verwenden, wobei der Metallanteil immer geringer wurde, um in der neusten Entwicklung ganz zu entfallen. Dadurch wurde jedoch der ganze Verpackungsprozess mit Folien schwieriger, insbesondere der dem Prägen folgende Faltungs- und Einpackungsprozess sowie die Logostrukturen immer feiner. Dies bedingt eine starke Erhöhung des Druckes der beiden miteinander kooperierenden Prägewalzen.

Infolge der Erhöhung des Druckes und Verringerung des Abstandes zwischen der mit Logos versehenen Prägewalze und der Gegenwalze wird insbesondere die Prägewalze mit den Logos derart verformt, dass ein gleichmässiges Prägen nicht mehr gewährleistet werden kann, insbesondere wenn es sich um sehr feine Strukturen auf der Prägewalze handelt. Dabei wird davon ausgegangen, dass in der Regel die Gegenwalze einen grösseren Umfang aufweist als die Prägewalze.

Im Prinzip ist es möglich, für jede Folienbeschaffenheit und Prägeart die Durchbiegung der Prägewalze Anhand von Mustern zu messen und eine Kompensation der Auswirkung der Durchbiegung direkt durchzuführen, doch ist ein solches Verfahren für die Produktion einer grossen Anzahl Walzen mit einer grossen Vielfalt von Prägemustern und Folien zu kostspielig und zu langwierig.

Es ist davon ausgehend Aufgabe der vorliegenden Erfindung ein Verfahren zur Herstellung eines Satzes von miteinander kooperierenden Prägewalzen anzugeben, das eine weitgehend vollständige Kompensation der Auswirkung der Durchbiegung der Prägewalze ermöglicht, wobei unter anderem die Art und Struktur der Oberfläche der Prägewalze, die Dicke und die Beschaffenheit der Folie und davon ausgehend der Druck zwischen den beiden Walzen berücksichtigt wird. Diese Aufgabe wird gemäss dem Verfahren nach Patentanspruch 1 gelöst, wobei zwecks Bestimmung der zur Herstellung des Satzes Prägewalzen notwendigen Parameter eine Modellvorrichtung verwendet wird. Weitere Aufgaben und Vorteile ergeben sich aus den abhängigen Ansprüchen und aus der nachfolgenden Beschreibung.

Die Erfindung wird im Folgenden anhand von Zeichnungen von Ausführungsbeispielen näher erläutert.
- Fig. 1: zeigt im Längsschnitt eine Walze einer Modellvorrichtung,
- Fig. 2: zeigt einen Schnitt gemäss der Linie II/II in Fig. 1,
- Fig. 3: zeigt einen Schnitt gemäss der Linie III/III in Fig. 1,
- Fig. 4: zeigt die Walze gemäss Fig. 1 in 3 verschiedenen perspektivischen Ansichten,
- Fig. 5: zeigt einen Teil einer der Walzen von Fig. 1 vor der Druckbeaufschlagung,
- Fig. 6: zeigt beide Walzen der Modellvorrichtung unter hydraulischem Druck,
- Fig. 7: zeigt ein mit Daten der Modellvorrichtung hergestelltes Prägewalzenpaar,
- Fig. 8: zeigt die gesamte Durchbiegung einer Achse einer Walze der Modellvorrichtung unter Druck,
- Fig. 9: zeigt die Durchbiegung der Achse gemäss Fig. 8 im mittleren Teil,
- Fig. 10: zeigt die Spannung der Achse von Fig. 8 unter Last,
- Fig. 11: zeigt die Verformung der Walze auf der der Prägekante gegenüberliegenden Seite und
- Fig. 12: zeigt die Verformung der Achse auf der Prägekante.

Um den definitiven Satz von Prägewalzen herstellen zu können, werden gemäss Erfindung deren Parameter mittels einer Modellvorrichtung ermittelt. Dabei wird die Auswirkung der Durchbiegung der Prägewalze durch die Geometrie der Gegenwalze kompensiert derart, dass die dickere Gegenwalze eine durch die Modellvorrichtung vorgegebene verformte Oberfläche erhält, die die Durchbiegung der Prägewalze bestimmt.

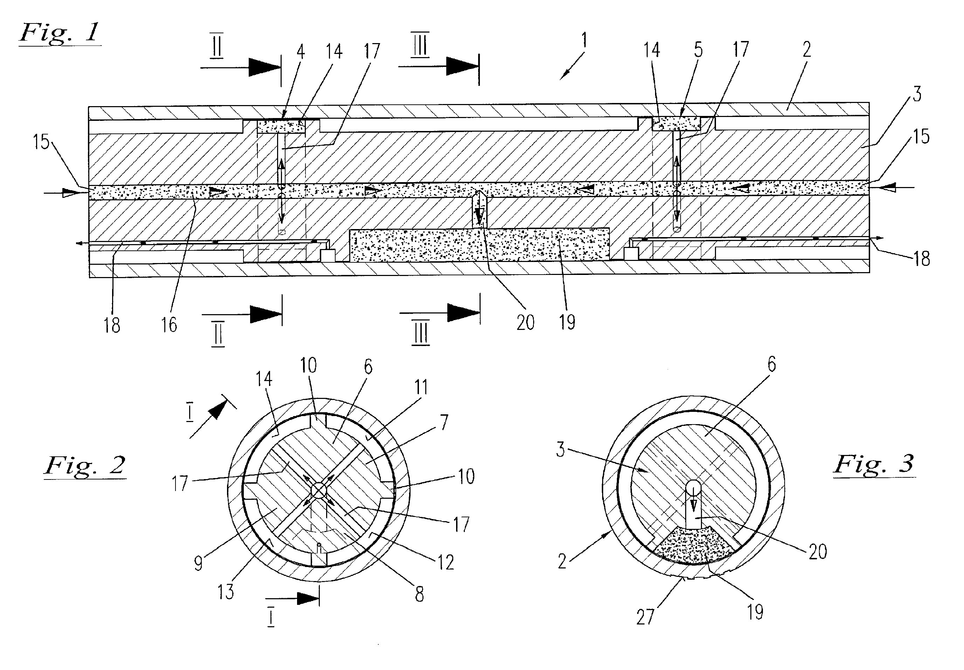

Fig. 1 zeigt einen Längsschnitt durch eine hydrostatisch gelagerte Walze 1 einer Modellvorrichtung, wobei diese Walze 1 einen Mantel 2 und eine Achse 3 aufweist. Um die Verformung der Achse unter Druck möglichst gering zu halten wird diese aus Hartmetall ausgeführt. Die Achse wird an zwei Lagerbereichen 4 und 5 im Mantel gehalten, wobei die hydrostatische Walze nur teilweise dargestellt ist.

Die Oberfläche des Mantels 2 ist mit Logos 27 versehen, die gleich denen, die auf der Prägewalze aufgebracht sind, sein können, oder Musterlogos, die beispielhaft für eine Reihe von Logos sein können.

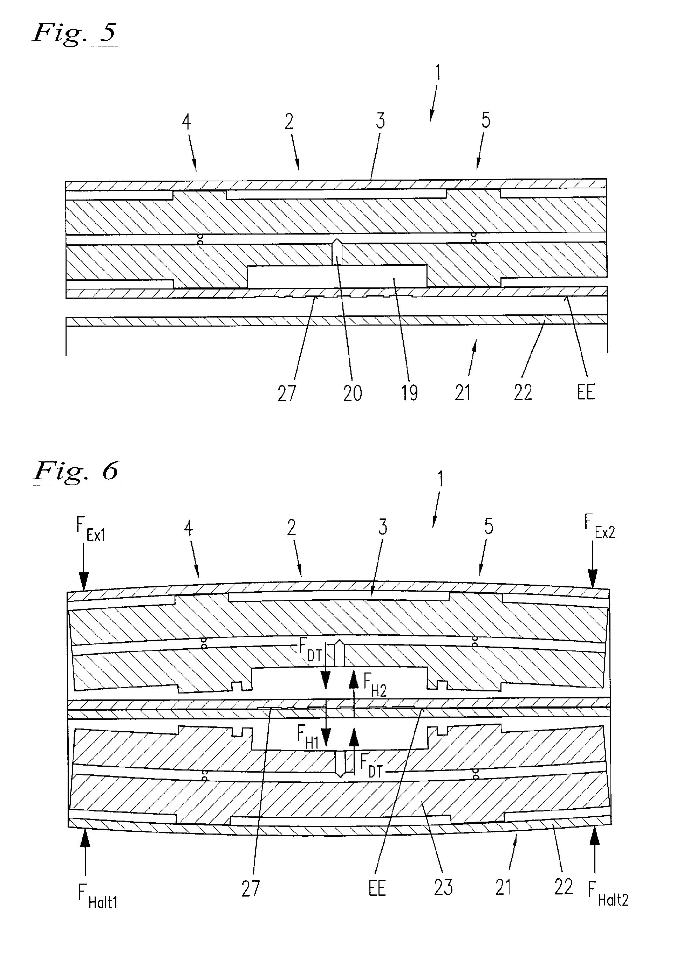

Der Zweck dieser Walzenanordnung ist, die Walzenachse unter einem bestimmten Druck zu setzen, um dessen Durchbiegung messen zu können. Dabei ist zu beachten, dass eine Walze allein nicht unter Druck gesetzt werden kann ohne Verformungen und Schäden anzurichten und dass das ganze Messsystem nur in der Konfiguration von Fig. 6 betrieben werden kann.

Um einen hydrostatischen Druck zu erzeugen sind in den beiden Lagerbereichen 4 und 5 jeweils vier Segmente 6, 7, 8 und 9 an einem Lagerteil der Achse angeordnet, wobei jedes Segment einen Zwischensteg 10 aufweist, wodurch zwischen den Achsensegmenten und dem Mantel vier Lagertaschen 11, 12, 13 und 14 entstehen, siehe Fig. 2. Das Druckmedium, beispielsweise Öl, gelangt von einem Einlass 15 in ein durchgehendes Rohr 16 und verteilt sich im Lagerbereich über vier Kanäle 17 zwischen den Segmenten und gelangt in die Lagertaschen. Der Rücklauf 18 auf beiden Seiten ist ebenfalls eingezeichnet.

Aus Fig. 1 ist ferner ersichtlich, dass die beiden Lagerbereiche 4 und 5 gegengleich ausgeführt sind. Aus Fig. 2 ist ersichtlich, dass bei Druckaufbau eine symmetrische Druckbeaufschlagung erfolgt, so dass die Achse und der Mantel koaxial gehalten werden. Bei Auslenkung aus der Mittelposition entsteht eine Rückstellkraft.

Wird nun von Aussen über die Achse, z.B. über deren Aufhängung, eine starke Kraft ausgeübt, das heisst eine Anpresskraft in Richtung einer Gegenwalze, so können die Lager diese Kraft in den Lagerbereichen nur begrenzt weitergeben, da diese eine symmetrische Anordnung haben. Die maximal erreichbare Anpresskraft der Walzen wäre begrenzt und im Bereich zwischen den Lager, dem eigentlichen Prägebereich, nicht homogen.

Darum wird in der Mitte der Achse eine weitere, zum Querschnitt der Achse nicht symmetrisch angeordnete, sektorielle Drucktasche 19 vorgesehen, siehe insbesonder Fig. 3. Diese wird über Zuleitung 20 vom Ölrohr 16 ebenfalls mit hydrostatischem Druck beaufschlagt. Die Drucktasche erlaubt es, die von Aussen auf die Achse ausgeübten Anpresskräfte über den Mantel an die Gegenwalze 21 und damit an die Prägekante PK zwischen den Walzen zu leiten.

Dies bedeutet, dass im statischen Betriebszustand der Maschine die externe Kraft und die der Drucktasche weitergegebene Kraft gerade gleich sind. Da die Achse diese Kraft mechanisch weiterleitet, kommt es zu einer Durchbiegung der Achse.

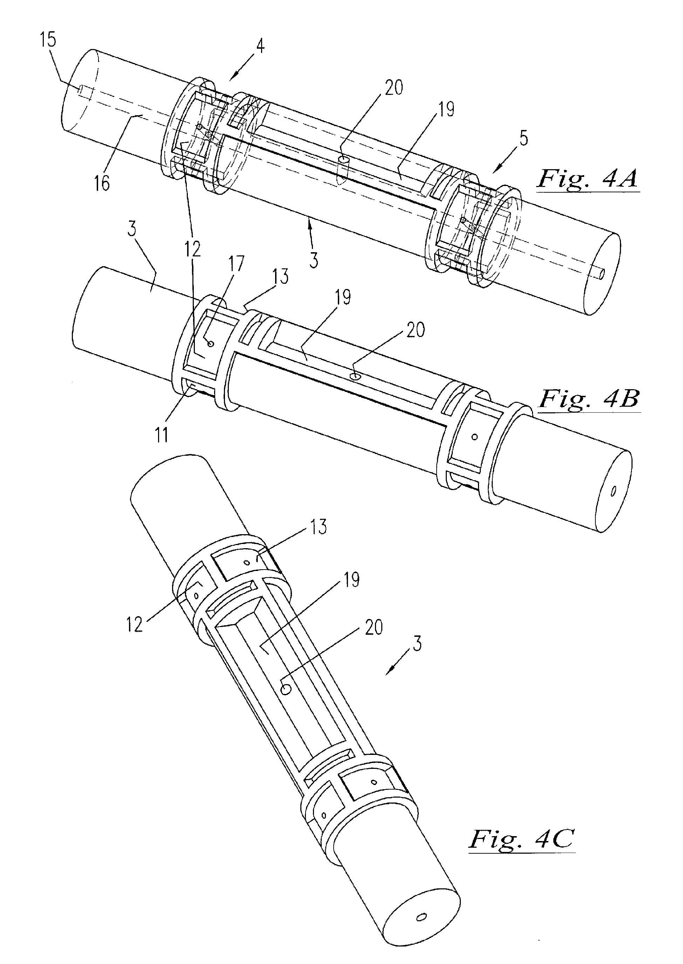

In den Figg. 4A, B, C sind drei verschiedene perspektivische Ansichten der Achse 3 dargestellt, wobei die Sicht jeweils auf die Drucktasche gerichtet ist. In diesen Ansichten erkennt man die Lage der in Figg. 1, 2 und 3 eingezeichneten Elemente.

In Fig. 5 ist eine der Walzen 1 der Modellvorrichtung eingezeichnet, wie sie sich vor der Druckbeaufschlagung darstellt. Von der zweiten Walze 21 ist gerade der Mantel 22 dargestellt sowie von Mantel 2 der ersten Walze die Prägekante EE, die stets gegenüber der Gegenwalze 21 zu liegen kommt.

In Figur 6 sind beide Walzen der Modellvorrichtung dargestellt, wie sie sich unter Druckbeaufschlagung verformen. Die beiden Walzen sind spiegelsymmetrisch zur Prägekante EE aufgebaut und es entsteht dadurch eine spiegelsymmetrische Kraftverteilung. Die Kräfte sind eingezeichnet, die bei externer Druckbeaufschlagung entstehen, die auf eine der Walzen, hier Walze 1 wirken. Sie sind mit FEX1 und FEX2 bezeichnet und entsprechen dem Druck auf die Prägewalzen. Dieser externe Druck wird von der Halterung aufgefangen und erzeugt einen Gegendruck FHalt1 und FHalt2.

Um die Achsen im Mantel zu lagern und um den externen Druck auf die Walzen auszugleichen und zu messen, wird ein hydraulisches Drucksystem benötigt, das hier mit hydraulischem Öl arbeitet. Dieses hydraulische Öl wird über die Zuleitung 15 auf die Lagertaschen und die Drucktasche geleitet.

An der Prägekante EE zwischen den beiden Walzen an der Stelle der beiden Drucktaschen treten gegengleiche Kräfte FH1, FH2 auf, in denen die auf die Drucktaschen wirkenden Kräfte FDT1 und FDT2 enthalten sind. Darum bleibt die Prägekante bei externen Druck absolut gerade. Die gegengleichen Kräfte auf die Walzen über den Drucktaschen entsprechen dem Prägedruck und werden von der Durchbiegung der Achsen aufgenommen. Daraus ergibt sich das Ziel dieser Messungen und Berechnungen, die Bestimmung der notwendigen Kraft an der Prägekante, um eine gute Prägequalität zu erreichen.

Somit ist eine einfache Berechnung des Kraftprofils möglich und dort wo die Drucktasche unterhalb liegt, entsteht ein homogenes Kraftprofil entlang einer geraden Kante. Dann kann vom gegebenen Druck auf die tatsächliche Kraftverteilung und damit auf die notwendige Prägekraft geschlossen werden.

Durch die Ausgestaltung der Modellvorrichtung, d. h. dadurch, dass die Prägekante stets genau eben ist, kann die Berechnung der Kräfteverhältnisse vereinfacht werden. Aus den sich ergebenden Messdaten, wie Kompensation der Durchbiegung der Achsen, kann diese Durchbiegung auf eine rein mechanischen Achse ohne hydrostatisches System umgerechnet werden und dadurch die Gestaltung bzw. geometrische Form der Gegenwalze.

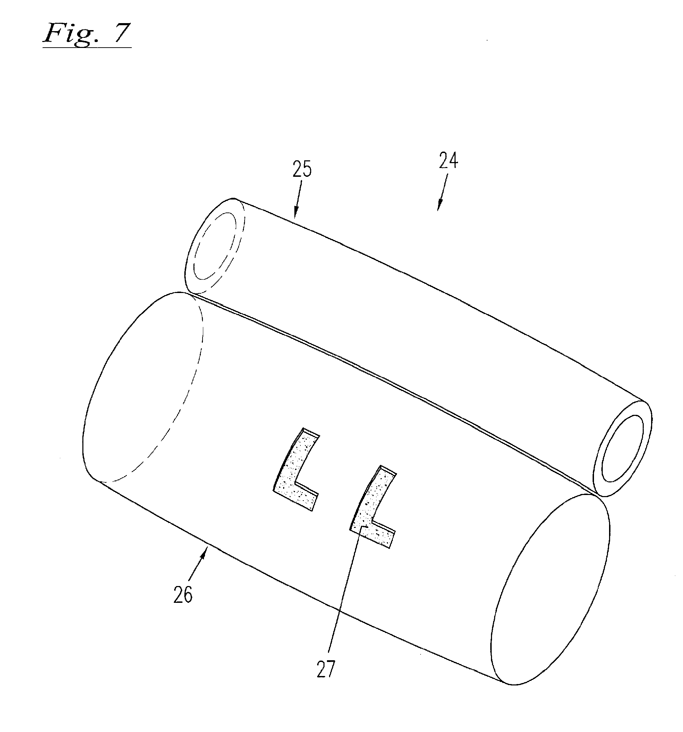

In Fig. 7 ist in perspektivischer Sicht und rein schematisch ein Prägewalzenpaar 24 angegeben, mit der dünneren Prägewalze 25 und der Gegenwalze 26 mit grösserem Durchmesser. Auf der Prägewalze sind symbolisch die Logos L eingezeichnet, die sehr kleine Strukturen aufweisen können.

Die Daten des hydrostatischen Walzensystems werden in Funktion der Oberflächenstruktur der herszutellenden Prägewalze sowie der zu prägenden Folie berechnet und eingegeben. Dann werden Durchläufe der Folie bei unterschiedllichen esxternen Drücken durchgeführt, bis sich die gewünschte Prägequalität eingestellt hat und der sich ergebende hydrostatische Druck gemessen. Aus diesem hydraulischen Druckwert kann mittels geeigneter Rechenprogramme die Werte für die geometrische Form der Gegenwalze berechnet werden. In vorliegendem Beispiel wird die Auswirkung der Durchbiegung der Prägewalze mittels einer Bombierung der Gegenwalze kompensiert.

Dabei wird davon ausgegangen, dass durch den einwirkenden externen Druck die normalerweise massivere Gegenwalze nur unmerklich verformt wird. Ausserdem wird die Bombierung derart berechnet, dass die Durchbiegung der Prägewalze durch die Bombierung vorgegeben wird, d. h., dass die Bombierung tendenziell etwas grösser ist als die Durchbiegung der Prägewalze alleine durch den Druck. Dadurch, dass die Bombierung der Gegenwalze die Durchbiegung der Prägewalze bestimmt kann erreicht werden, dass der Spalt zwischen beiden Walzen beim Prägen mit einer grossen Genauigkeit konstant bleibt.

Anstatt vier Lagertaschen können auch eine andere Anzahl Lagertaschen vorgesehen sein, doch muss der hydraulische Druck symmetrisch auf die Achse sein. Ausserdem kann auch mehr als eine Drucktasche vorgesehen werden.

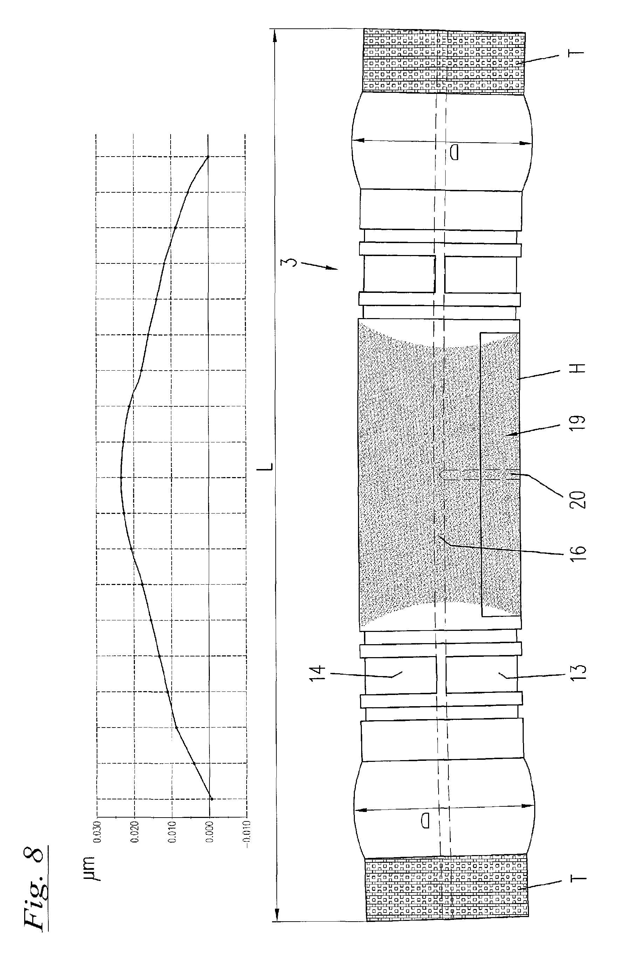

Die Figg. 8 - 12 stellen Messergebnisse dar, die bei Messungen an einer Achse in einer hydrostatischen Zweiwalzen-Modellvorrichtung gewonnen wurden. Bei diesen Versuchen sind beide Walzen in einer nicht gezeigten Lagerung eines Gehäuses eingespannt und der Druck wird auf eine Achse, die dargestellte, gegeben, wobei sich alle Figuren auf einen Druck beziehen, der einer Kraft von 15'000 Newton (N) entspricht und die Achse eine Länge L von 225 mm und einen Durchmesser D von 48mm aufweist.

In Fig. 8 ist die volle Durchbiegung der Achse berechnet, wobei gemäss dem Diagramm insgesamt etwa 24 µm Durchbiegung resultierten. Diese Daten gelten bei vollem Druck der Maschine. Der punktierte Bereich in der Mitte der Achse entspricht dem erhöhten Druck H und somit Durchbiegung. Die beiden äusseren, gemustert dargestellten Bereiche T der Achse stehen weder unter Druck noch zeigen sie eine Durchbiegung, da sie dort gehalten werden.

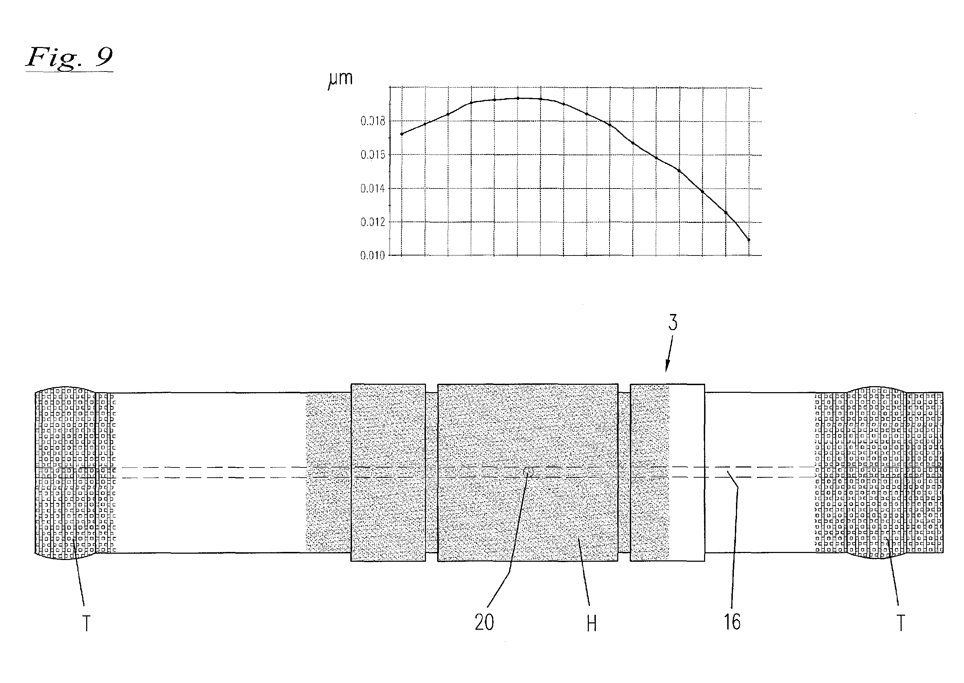

Das Diagramm von Fig. 9 zeigt eine Berechnung der Durchbiegung der Hartmetallachse in der Mitte der Achse, d. h. über der Drucktasche 19, wo sich eine Durchbiegung von etwa 8 µm ergibt. Das Diagramm ist nicht symmetrisch zum Achsenmittelpunkt angeordnet und wurde einerseits derart gewählt, um in den Aussenbereichen der Lager ebenfalls die Durchbiegung zu kennen und andererseits auch, um die Durchbiegung innerhalb des Lagerbereiches zu kennen und so das Spiel des Lagers berücksichtigen zu können. Auf die Drucktasche wurde ein Druck von etwa 100 bar gegeben, um die Durchbiegung zu kompensieren. Der punktierte Bereich in der Mitte der Achse symbolisiert die erhöhte Durchbiegung in diesem Bereich. Bei der Verwendung einer Stahlachse wäre die Durchbiegung etwa 3x so gross. Die Stellung der Achse ist in Fig. 9 um 90° gegenüber der Stellung von Fig. 8 gedreht.

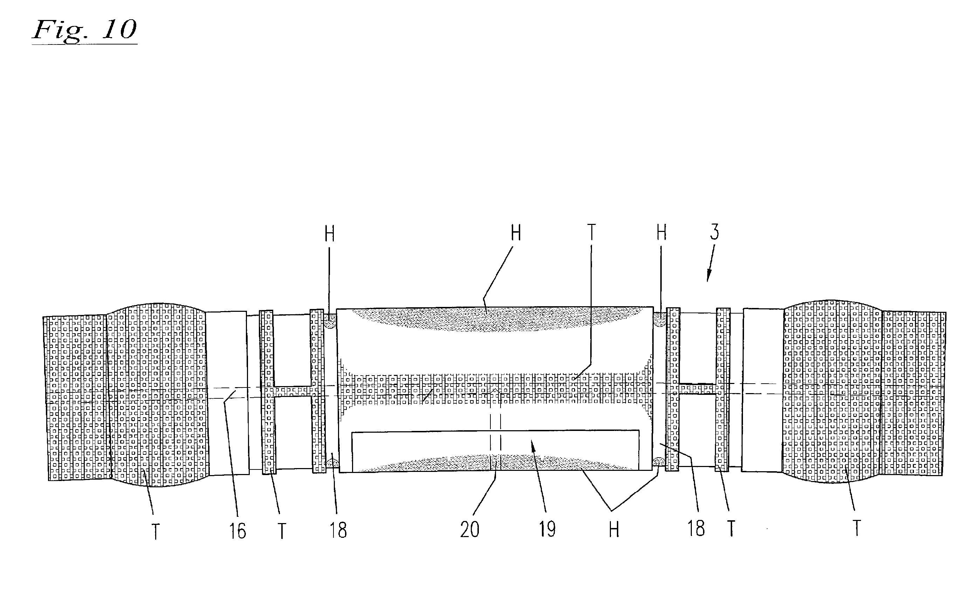

In Fig. 10 ist die Spannung der Achse in der Stellung von Fig. 8 gezeigt und es ergibt sich daraus, dass die Spannung an der der Drucktasche entgegengesetzten Seite am grössten ist und im Mittelbereich zwischen Drucktasche und der entgegengesetzten Seite die Spannung sehr gering ist, wie dies zeichnerisch durch verschiedene Musterungen H und T gezeigt ist.

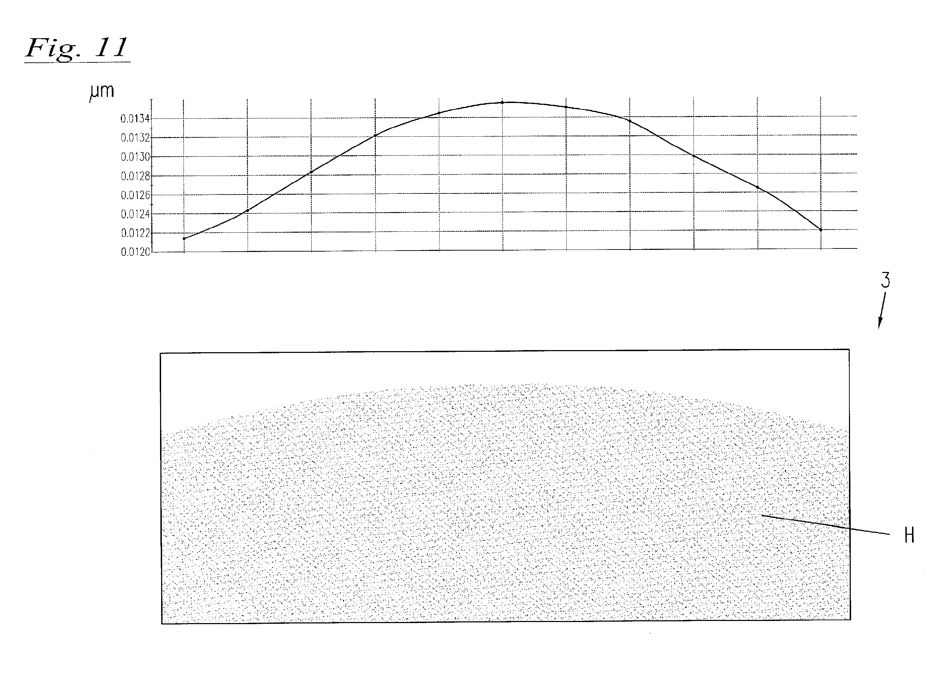

In Fig. 11 ist die Verformung der Achse auf der der Drucktasche entgegengesetzten Seite angegeben, wobei die Drucktaschenseite der Prägekante entspricht, die bei Rotation der Walze jeweils an der der Gegenwalze gegenüber liegenden Stelle entsteht und wo die Folie durchgeführt wird. Aus der Musterung H ist eine relativ grosse Verformung sichtbar, die jedoch nirgends die Grenzbelastung des Mantels erreicht, so dass es nicht zu einem Materialversagen kommen kann. In vorliegendem Fall erreicht die Verformung etwa 14 µm.

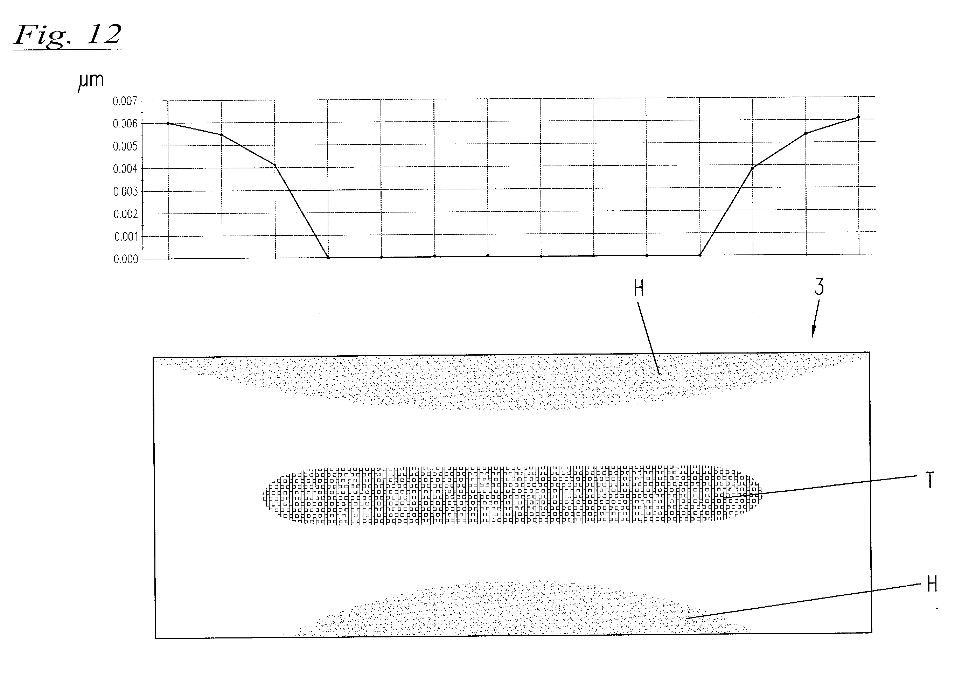

In Fig. 12 ist die Verformung der Walze an der Prägekante dargestellt, wobei der gleiche Druck wie bei Fig. 11 verwendet wurde und woraus sich ergibt, dass an der Prägekante infolge der Drucktasche und der Tatsache, dass dieser Prägekante eine zweite Walze mit identischen Daten entgegensteht, keine Durchbiegung erfolgt.

Aus den vorhergehenden Figuren und der Beschreibung geht hervor, dass mit der Modellvorrichtung mit zwei hydrostatisch gelagerten Walzen mit Hartmetallachsen sowie Drucktaschen es möglich ist, durch Einstellung des hydraulischen Druckes, der auf die Lagertaschen sowie auf die Drucktaschen wirkt, die jeweilige Durchbiegung der Achse zu berechnen. Der optimale Anpressdruck wird durch Versuche mit einem der Prägewalze entsprechenden Muster und der zu verwendenden Folie eingestellt und der hydraulische Gegendruck in den Lagertaschen und der Drucktasche gemessen. Aus diesen Daten können die Parameter für die Geometrie der Präge- und Gegenwalze berechnet werden.

Ausgehend von der beschriebenen Modellvorrichtung ist es auch denkbar, anstatt eines hydraulischen Systems mit Öl oder Druckluft eine andere Modellvorrichtung mit Druckaufnehmern oder anderen ähnlichen Messsystemen zu verwenden und die Belastung der Achsen sowie deren Durchbiegung anhand von anderen Parametern auszurechnen.

Ferner kann sich eine andere Verformung der Prägewalzen und somit Geometrie der Oberfläche der Gegenwalze ergeben. Ziel der ganzen Berechnungen bleibt, die Geometrie der der Prägewalze entsprechenden Gegenwalze derart berechnen zu können, dass beim Prägen einer bestimmten Folie und einer bestimmten Prägestruktur auch bei Verwendung von sehr kleinen Prägeelementen und hohen Drücken eine gleichmässige Prägung über die gesamte Breite der Folie erzeugt wird.

## Patentansprüche

1. Verfahren zur Herstellung eines Satzes von miteinander kooperierenden Prägewalzen, **dadurch gekennzeichnet, dass** für die Parametrisierung der Prägewalzen eine Modellvorrichtung verwendet wird, die ein Paar Walzen aufweist, die unter mess- und einstellbaren Druck gesetzt werden, um aus den Messdaten die Parameter zur Herstellung der Prägewalzen zu bestimmen.

2. Verfahren nach Anspruch 1, **dadurch gekennzeichnet, dass** die Walzen der Modellvorrichtung unter externen sowie hydraulischen Druck versetzt werden und die Verbiegung einer der Walzen gemessen wird, um daraus die geometrische Form der Oberfläche der Gegenwalze im Prägewalzensatz zu bestimmen.

3. Verfahren nach Anspruch 2, **dadurch gekennzeichnet, dass** die Modellvorrichtung zwei Walzen mit je einen Mantel und einer Achse aufweist, die an beiden Enden in einer Lagerung in einem Gehäuse gelagert sind und unter hydrostatischen Druck versetzt werden und auf eine der Walzen ein externer Druck erzeugt wird, dessen Auswirkung auf die Walzenachse gemessen wird.

4. Verfahren nach einem der Ansprüche 1 bis 3, **dadurch gekennzeichnet, dass** die Modellvorrichtung Elemente aufweist, um aus der extern auf eine Walze aufgebrachten Kraft den Verlauf der Durchbiegung einer Achse zu messen.

5. Verfahren nach Anspruch 4, **dadurch gekennzeichnet, dass** die Messdaten verwendet werden, um die Geometrie der Oberfläche der Gegenwalze des Prägewalzen-Satzes zu bestimmen.

6. Verfahren nach Anspruch 4, **dadurch gekennzeichnet, dass** die geometrische Form der Oberfläche der Gegenwalze eine Bombierung ist, die etwas grösser gewählt wird als die Durchbiegung der Prägewalze durch den externen Druck.

7. Modellvorrichtung zur Durchführung des Verfahrens nach einem der Ansprüche 1 bis 6 zur Bestimmung der Parameter zur Herstellung eines Satzes von Prägewalzen, **dadurch gekennzeichnet, dass** die Modellvorrichtung zwei Walzen (1, 21) aufweist, wobei jede Walze eine hydrostatisch in einem Mantel (2, 22) in zwei Lagerbereichen (4, 5) gelagerte Achse (3, 23) und Mittel (15, 11-14; 19) aufweist, um einen einstellbaren und messbaren Gegendruck zum externen Druck auf die Achse zu erzeugen und einer der Mantel an seiner Oberfläche im Bereich der Drucktasche Logos (27) aufweist.

8. Vorrichtung nach Anspruch 7, **dadurch gekennzeichnet, dass** die Mittel Ausnehmungen (11 - 14) an der Achse sind, die mit einer Hydrauliköl-Leitung (15) verbunden sind, um einen hydrostatischen Druck zu erzeugen.

9. Vorrichtung nach Anspruch 8, **dadurch gekennzeichnet, dass** die Achse (3, 23) mindestens eine als Drucktasche (19) dienende sektorförmige Ausnehmung aufweist und beidseitig im Mantel (2, 22) in einem Lagerbereich (4, 5) gehalten ist, wobei die Achse im Lagerbereich symmetrisch angeordnete, als Lagertaschen (11-14) dienende Ausnehmungen aufweist, um je ein hydrostatisches Lager zu bilden und sowohl die Drucktasche als auch die Lagertaschen mit der Ölleitung (15, 16) verbunden sind.

10. Vorrichtung nach einem der Ansprüche 7 bis 9, **dadurch gekennzeichnet, dass** sie eine Einstell- und Auswerteeinheit aufweist, um bei gegebenen externen Druck den hydraulischen Druck einzustellen und aus den Messergebnissen die geometrische Form der Oberfläche der Gegenwalze (26) zu errechnen.
